# FASCICULE DE BREVET EUROPEEN

(11) **EP 0 406 060 B1**
(45) Date de publication et mention de la délivrance du brevet: **10.05.1995**
(21) Numéro de dépôt: 90401712.6
(22) Date de dépôt: 19.06.1990
(51) Int. Cl.: G11B 5/39, G01R 33/06

(54) **Capteur à effet magnétorésistif**
Magnetwiderstandseffektwandler
Magnetoresistive effect transducer

(30) Priorité: 27.06.1989 FR 8908545
(43) Date de publication de la demande: 02.01.1991
(73) Titulaire: THOMSON-CSF, 75008 Paris (FR)
(72) Inventeur: Friederich, Alain, F-92045 Paris la Défense (FR); Creuzet, Gérard, F-92045 Paris la Défense (FR)
(74) Mandataire: Ruellan-Lemonnier, Brigitte

(56) Documents cités:
- EP-A- 0 288 766
- EP-A- 0 314 343
- US-A- 4 103 315
- PHYSICAL REVIEW, B. CONDENSED MATTER. vol. 39, no. 7, 1 mars 1989, NEW YORK US pages 4828 - 4830; G. Binasch & al.: "Enhanced magnetoresistance in layered magnetic structures with antiferromagnetic interlayer exchange"
- PHYSICAL REVIEW LETTERS. vol. 61, no. 21, 21 novembre 1988, NEW YORK US pages 2472 - 2475; M.N. Baibich & al.: "Giant magnetoresistance of (001) Fe/(001)Cr magnetic superlattices"

## Description

La présente invention concerne les capteurs à effet magnétorésistif, à savoir les capteurs utilisant la variation de résistivité du matériau formant le capteur en fonction de la variation d'un champ magnétique.

Actuellement, des capteurs utilisant l'effet magnétorésistif sont mis en oeuvre dans divers systèmes de lecture d'enregistrement magnétique. Ces capteurs sont réalisés en un alliage ferromagnétique à forte magnéto-résistance qui est placé dans le circuit magnétique d'une tête de lecture. Dans ce cas, on détecte les variations de la résistance électrique du capteur lors du passage de la bande. Les alliages à forte magnétorésistance actuellement utilisés sont en général des alliages ferromagnétique à base de nickel, tels que les alliages de type Ni₈₀Fe₂₀ ou des alliages Ni Co pour lesquels la magnétorésistance à température ambiante correspond à une variation de résistance de quelques pour cent.

L'un des principaux inconvénients de ces capteurs réside dans leur bruit. En effet, ces alliages ne sont pas monocristallins et ils présentent de nombreux domaines magnétiques pour les champs magnétiques correspondant au point de fonctionnement du capteur. Ces nombreux domaines magnétiques sont la cause principale de bruit.

La présente invention a pour but de remédier à ces inconvénients en proposant une nouvelle structure pour l'élément sensible des capteurs à effet magnétorésistif.

Ainsi, la présente invention a pour objet un capteur à effet magnétorésistif dont l'élément sensible du capteur est constitué par une multicouche métallique magnétique monocristalline, la multicouche étant formée d'un empilement de couches en un matériau magnétique séparées par des couches en un matériau non-magnétique, la multicouche étant réalisée de telle sorte que les couches en matériau magnétique présentent un couplage de type anti-ferromagnétique, que la transition entre l'état d'arrangement anti-parallèle et l'état d'arrangement parallèle se réalise sur un intervalle de champ magnétique très faible, et que la transition entre l'état d'arrangement anti-parallèle et l'état d'arrangement parallèle est de type "spin-flop" caractérisé en ce que la multicouche métallique magnétique est recouverte d'au moins une couche supplémentaire à aimantation bloquée exerçant un champ de polarisation H_{b} dont la valeur est très proche du champ de "spin-flop" H_{sf}, afin de décaler la transition vers des valeurs de champ magnétique correspondant à l'application d'un champ magnétique extérieur très faible.

De préférence, le matériau magnétique utilisé dans la multicouche métallique magnétique est choisi parmi le fer, le cobalt ou le nickel et le matériau non magnétique est choisi parmi le manganèse, le chrome, le vanadium ou le titane.

Les couches en matériau magnétique présentent une épaisseur comprise en 9 et 90 Å et les couches en matériau non magnétique présentent une épaisseur inférieure à 30 Å.

Ainsi, en utilisant certains types de matériaux magnétiques et non-magnétiques, associés selon une structure spécifique, on a pu observer une forte magnétorésistance se produisant dans un domaine de champ restreint permettant donc son utilisation comme élément sensible d'un capteur à effet magnétorésistif. Cette forte magnétorésistance observée notamment dans le cadre des multicouches métalliques magnétiques Fe/Cr est due à la transition sous champ magnétique entre les deux états d'aimantation du système, à savoir l'état où l'alternance des aimantations des couches magnétiques est anti-parallèle et l'état où toutes ces aimantations sont parallèles.

Selon une autre caractéristique de la présente invention, les couches en matériau magnétique sont alternativement minces et épaisses avec un rapport entre les épaisseurs compris entre 1 et 3.

Dans ce cas, la transition entre l'état d'arrangement anti-parallèle et l'état d'arrangement parallèle sera de type "spin-flop" (à savoir : par retournement brutal de l'aimantation des couches de faible épaisseur à un champ donné appelé champ de spin-flop).

Selon une autre caractéristique de la présente invention, les couches en matériau magnétique sont de même épaisseur, la multicouche présentant alors une anisotropie uni-axiale dans le plan des couches.

Selon la présente invention, la multicouche métallique magnétique recouverte d'au moins une couche supplémentaire à aimantation bloquée. Dans ce cas, on décale le champ magnétique de "spin-flop" vers des champs très faibles. Cette solution permet de réduire ou même éventuellement de supprimer le champ magnétique de polarisation nécessaire lorsque le système ne fonctionne pas près d'un champ nul.

Le document Physical Review, vol. 61, n° 21, 21 Novembre 1988, pages 2472-2475, M.N. BAIBICH et al décrit l'effet magnétorésistif dans des multicouches métalliques-magnétiques. Ce document correspond au préambule de la revendication 1. Le document Physicial Review B, vol. 39, n° 7, 1 Mars 1989, pages 4828-4830, G. BINASCH et al indique que des structures multicouches magnétiques peuvent être utilisées comme senseur de champ magnétique.

D'autres caractéristiques et avantages de la présente invention apparaîtront à la lecture de la description faite ci-après de différents modes de réalisation d'un capteur à effet magnétorésistif avec référence aux dessins ci-annexés dans lesquels :
- la figure 1 est une vue en coupe schématique d'un premier mode de réalisation d'un capteur à effet magnétorésistif conforme à la présente invention ;
- les figures 2A et 2B sont des vues en coupe de l'élément sensible du capteur expliquant le fonctionnement de ce capteur ;
- la figure 3 est une vue en coupe schématique de l'élément sensible d'un capteur à effet magnétorésistif selon un autre mode de réalisation de la présente invention ;
- les figures 4A et 4B sont des vues semblables à la figure 3 expliquant le fonctionnement dudit capteur ;
- la figure 5 représente le cycle d'hystéréris du capteur de figure 3 ;
- la figure 6 est une vue en coupe schématique d'un troisième mode de réalisation d'un capteur à effet magnétorésistif conforme à la présente invention, et
- la figure 7 représente le cycle d'hystérésis d'un capteur selon la figure 6.

Pour simplifier la description, dans les figures les mêmes éléments portent les mêmes références. D'autre part, il est évident pour l'homme de l'art que, dans un but de clarté, les épaisseurs des différentes couches n'ont pas été représentées à l'échelle.

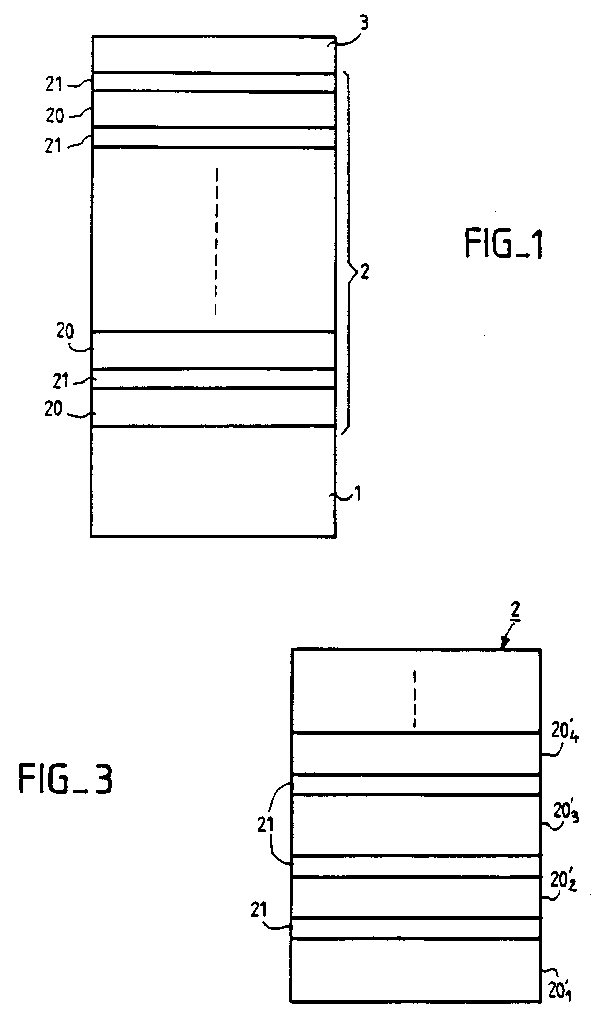

Comme représenté sur la figure 1, un capteur à effet magnétorésistif comporte essentiellement un substrat 1, une multicouche métallique magnétique monocristalline 2 formée par un empilement de couches 20 en matériau magnétique séparées par des couches 21 en matériau non magnétique, et recouvertes d'une couche d'encapsulation 3. Le substrat 1 est réalisé soit en un matériau isolant ou en un matériau semiconducteur non dopé tel que l'arseniure de gallium (AsGa).

Sur ce substrat 1 est déposée une multicouche métallique magnétique monocristalline. En fait, le substrat 1 doit présenter une structure de mailles adaptée de telle façon que la croissance de la multicouche soit réalisée de manière à obtenir un monocristal. Pour obtenir ce monocristal, on utilise des techniques de croissance telle que la croissance par epitaxie, de préférence l'épitaxie par jets moléculaires appelée aussi épitaxie MBE. Ainsi, avec un monocristal, pour une couche donnée, les états magnétiques sont monodomaines, ce qui a pour principal avantage de réduire considérablement le bruit associé.

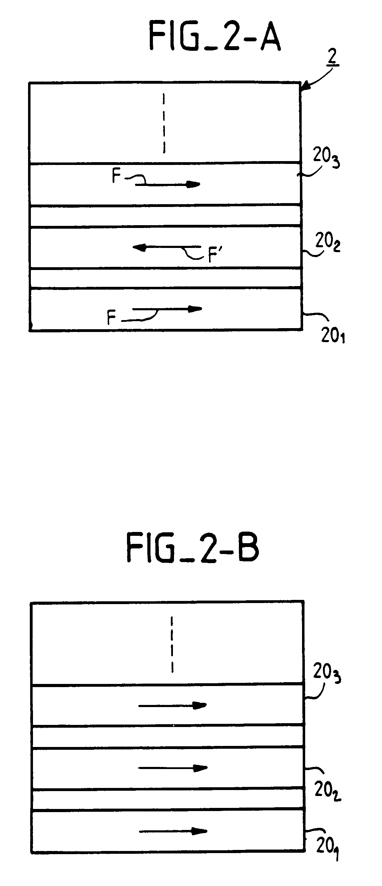

Conformément à la présente invention, le matériau magnétique des couches 20 est choisi parmi le fer, le cobalt, le nickel ou un alliage de ces métaux, de même le matériau non magnétique des couches 21 est choisi parmi le manganèse, le chrome, le vanadium ou le titane. D'autre part, les couches 20 en matériau magnétique présentent une épaisseur comprise entre 9 et 90 Å tandis que les couches 21 en matériau non magnétique présentent une épaisseur inférieure à 30 Å de façon à obtenir une structure de multicouche particulière. Avec la structure ci-dessus utilisée pour la multicouche 2, le couplage entre les couches magnétiques 20₁, 20₂, 20₃ telles que représentées sur la figure 2A est de type anti-ferromagnétique, c'est-à-dire qu'elle présente un arrangement anti-parallèle symbolisé par les flèches F et F′ sur la figure 2A, pour les aimantations des couches. La structure de la multicouche est telle qu'elle passe de l'arrangement anti-parallèle de la figure 2A à un arrangement parallèle tel que représenté sur la figure 2B pour un intervalle de champ magnétique très faible, de quelques Gauss, soit à partir d'un champ nul, soit à partir d'un champ fini. Dans ce dernier cas, il faut alors utiliser un champ magnétique de polarisation pour fixer le point de fonctionnement du capteur au voisinage de ce champ.

C'est en fait cette transition entre l'état de la figure 2A et l'état de la figure 2B qui induit une forte magnétorésistance dans le type de structure décrit ci-dessus. Ainsi, l'obtention d'une forte magnétorésistance associée à la transition de l'état d'arrangement anti-parallèle en un état d'arrangement parallèle peut s'expliquer grâce à la notion de résistivité dépendante du spin pour des impuretés dans des matériaux ferromagnétiques tels que le fer, le cobalt ou le nickel. En fait, l'état avec arrangement parallèle possède une résistance faible si on choisit un matériau non magnétique qui diffuse peu les électrons de conduction pour au moins une direction de spin. En revanche, l'état avec arrangement anti-parallèle aura une résistivité plus importante. Ainsi, pour pouvoir réaliser un capteur à effet magnétorésistif, en utilisant comme élément sensible une multicouche métallique magnétique monocristalline, il est nécessaire que cette multicouche présente une structure particulière et soit réalisée à l'aide de matériaux ferromagnétiques et de matériaux non magnétiques spécifiques de manière à ce que les couches en matériau magnétique présentent un couplage de type anti-ferromagnétique et que la transition entre l'état d'arrangement anti-parallèle et l'état d'arrangement parallèle se réalise sur un intervalle de champ magnétique très faible. En effet, suite à des études effectuées, notamment sur les multicouches de type Fe/Cr, on s'est aperçu que l'obtention d'une forte magnétorésistance est liée étroitement à la nature du matériau non-magnétique. On peut considérer que la diffusion par la couche mince non-magnétique dans le cas d'un arrangement parallèle tel que représenté sur la figure 2B est semblable à celle d'impuretés du matériau non-magnétique dans le matériau magnétique. Ceci explique le choix du matériau non magnétique. Cependant, l'utilisation de certains matériaux comme élément de base d'un capteur magnétorésistif est de plus subordonnée au fait que le couplage entre les couches magnétiques soit de type anti-ferromagnétique et que la transition entre l'état d'arrangement anti-parallèle et l'état d'arrangement parallèle se réalise sur un intervalle de champ très faible.

De façon générale, on peut prévoir que des couches non-magnétiques réalisées en tout métal de transition, à cause de la forte propension qu'ont les électrons de la couche de bande d à se polariser magnétiquement, établira un couplage entre couches magnétiques pour des épaisseurs de même ordre de grandeur. Cependant, suivant le type de matériau non-magnétique utilisé, ce couplage peut être un couplage ferromagnétique ou un couplage anti-ferromagnétique, ce qui explique le choix des matériaux non magnétiques.

De plus, selon la position en champ magnétique de la transition entre les arrangements parallèles et les arrangements anti-parallèles, on peut être amené à utiliser un champ de polarisation qui polarise le système au voisinage du champ de transition.

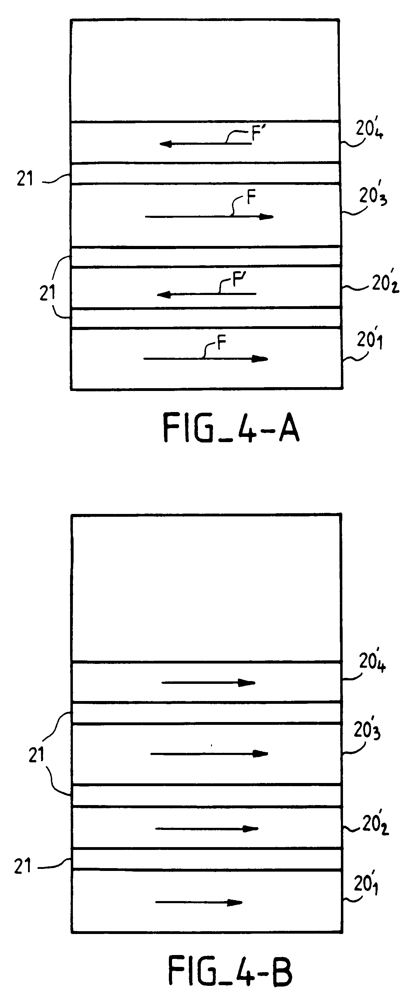

Sur la figure 3, on a représenté une variante de réalisation de la multicouche métallique magnétique monocristalline 2 d'un capteur à effet magnétorésistif. Dans ce cas, les couches magnétiques 20′₁, 20′₂, 20′₃ et 20′₄ sont constituées par des couches d'épaisseurs variables. Dans le mode de réalisation représenté, les couches 20′₁ et 20′₃ sont des couches épaisses tandis que les couches 20′₂ et 20′₄ sont des couches minces. En fait, les couches doivent être réalisées de manière à ce que leur épaisseur se trouve dans un rapport de 1 à 3.

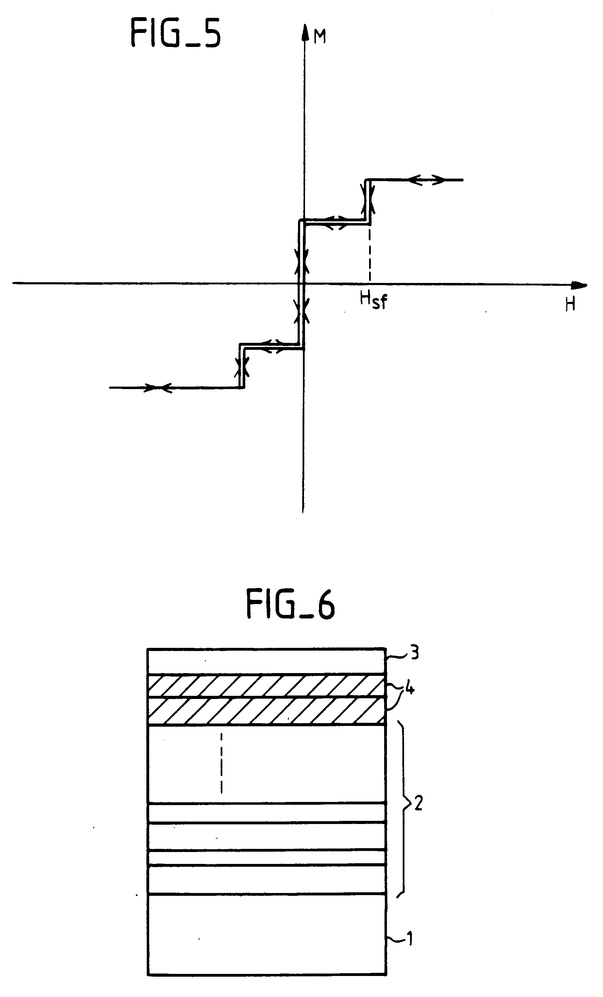

Comme représenté sur les figures 4A et 4B, la transition entre l'état d'arrangement anti-parallèle de la figure 4A et l'état d'arrangement parallèle de la figure 4B sera alors du type "spin-flop". Ainsi, un faible champ magnétique commence par orienter dans sa direction l'aimantation des couches épaisses 20′₁, 20′₃, les couches fines 20′₂, 20′₄ ayant leur aimantation dans la direction opposée F′. Un champ caractéristique ou champ de "spin-flop" H_{sf}, renversera ensuite brutalement l'aimantation des couches fines 20′₂ et 20′₄ dans le mode de réalisation représenté. Dans ce cas, on obtient le cycle d'hystérésis représenté sur la figure 5. Il est, alors, nécessaire d'utiliser un champ de polarisation H_{b} dont la valeur est très proche de H_{sf} afin que la transition se produise pour l'application d'un champ magnétique de l'ordre de grandeur de celui qui est mis en jeu dans la lecture des bandes magnétiques.

En fait, l'obtention d'un cycle d'hystérésis tel que celui représenté dans la figure 5 peut aussi être réalisé avec des multicouches métalliques magnétiques possèdant des couches magnétiques d'épaisseur égale, si le système possède une anisotropie uni-axiale dans le plan des couches comme par exemple lorsque le système est réalisé avec une épitaxie de type (110) bcc ou fcc.

Sur la figure 6 on a représenté un troisième mode de réalisation d'un capteur à effet magnétorésistif conforme à la présente invention. Dans ce cas, sur la multicouche métallique magnétique 2, on a déposé au moins une couche supplémentaire 4 (deux dans le mode de réalisation) à aimantation bloquée dans une direction donnée. Cette couche supplémentaire à aimantation bloquée est constituée, par exemple, par une couche épaisse de fer.

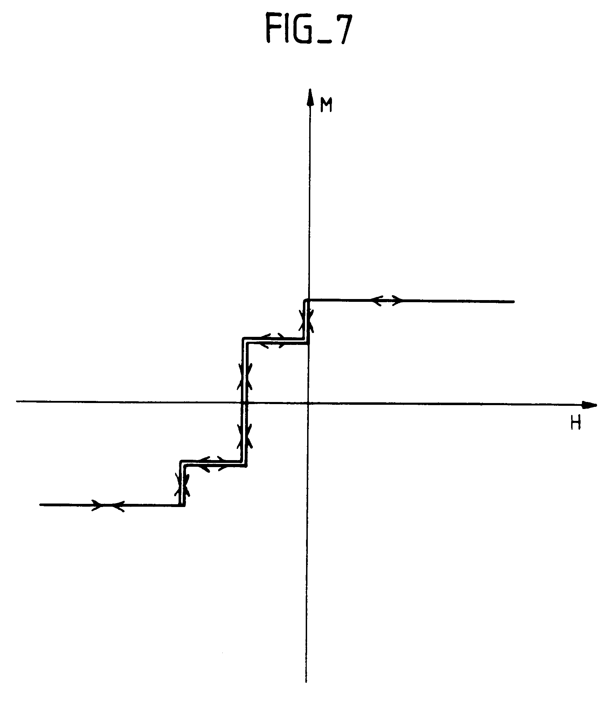

Ces couches supplémentaires permettent de décaler le champ de "spin-flop" H_{sf} vers des champs magnétiques très faibles. Le processus mis en jeu pour décaler le champ magnétique de "spin-flop" H_{sf} est alors le processus classique d'anisotropie d'échange avec ces couches supplémentaires. Cette solution permet soit de réduire le champ de polarisation H_{b}, soit même de le supprimer totalement. Le cycle d'hystérésis obtenu dans ce dernier cas est un cycle tel que représenté sur la figure 7.

## Revendications

1. Capteur à effet magnétorésistif dont l'élément sensible du capteur est constitué par une multicouche métallique magnétique monocristalline (2), la multicouche étant formée d'un empilement de couches (20′) en un matériau magnétique séparées par des couches (21) en un matériau non-magnétique, la multicouche étant réalisée de telle sorte que les couches en matériau magnétique présentent un couplage de type anti-ferromagnétique, que la transition entre l'état d'arrangement anti-parallèle et l'état d'arrangement parallèle se réalise sur un intervalle de champ magnétique très faible, et que la transition entre l'état d'arrangement anti-parallèle et l'état d'arrangement parallèle est de type "spin-flop" caractérisé en ce que la multicouche métallique magnétique est recouverte d'au moins une couche supplémentaire (4) à aimantation bloquée exerçant un champ de polarisation H_{b} dont la valeur est très proche du champ de "spin-flop" H_{sf}, afin de décaler la transition vers des valeurs de champ magnétique correspondant à l'application d'un champ magnétique extérieur très faible.

2. Capteur à effet magnétorésistif selon la revendication 1, caractérisé en ce que la transition de type "spin-flop" est réalisée par le fait que les couches en matériau magnétique sont alternativement minces (20′₂ et 20′₄) et épaisses (20′₁ et 20′₃) avec un rapport entre les épaisseurs de 1 à 3.

3. Capteur à effet magnétorésistif selon la revendication 1, caractérisé en ce que la transition de type "spin-flop" est réalisée par le fait que la multicouche est formée d'un empilement de couches (20) de même épaisseur en un matériau magnétique séparé par des couches (21) de même épaisseur en un matériau non magnétique et en ce qu'elle présente une anisotropie uni-axiale dans le plan des couches.

4. Capteur à effet magnétorésistif selon la revendication 1, caractérisé en ce que le matériau magnétique est choisi parmi le fer, le cobalt ou le nickel.

5. Capteur à effet magnétorésistif selon la revendication 1, caractérisé en ce que le matériau non-magnétique est choisi parmi le manganèse, le chrome, le vanadium ou le titane.

6. Capteur à effet magnétorésistif selon la revendication 1, caractérisé en ce que les couches en matériau magnétique présentent une épaisseur comprise entre 9 et 90 A.

7. Capteur à effet magnétorésistif selon la revendication 1, caractérisé en ce que les couches en matériau non-magnétique présentent une épaisseur inférieure à 30 A.

8. Capteur à effet magnétorésistif selon la revendication 1, caractérisé en ce que la couche supplémentaire est constituée par une couche épaisse de fer.

9. Capteur à effet magnétorésistif selon la revendication 1, caractérisé en ce que l'intervalle de champ magnétique est de l'ordre de quelques Gauss.

10. Capteur à effet magnétorésistif selon la revendication 1, caractérisé en ce qu'il est polarisé par un champ de polarisation voisin du champ de transition.

11. Capteur à effet magnétorésistif selon la revendication 1, caractérisé en ce que la multicouche (2) est déposée sur un substrat (1).

12. Capteur à effet magnétorésistif selon la revendication 11, caractérisé en ce que le substrat est réalisé en un matériau isolant ou en un matériau semiconducteur non dopé à structure de mailles adaptée.

13. Capteur à effet magnétorésistif selon l'une quelconque des revendications 11 et 12, caractérisé en ce que le dépôt est réalisé en utilisant une technique d'épitaxie telle que l'épitaxie par jets moléculaires.

14. Capteur à effet magnétorésistif selon l'une quelconque des revendications 1 à 13, caractérisé en ce que la multicouche (2) est recouverte d'une couche d'encapsulation (3).

## Patentansprüche

1. Magnetoresistive Sonde, deren empfindliches Element aus einer monokristallinen, metallischen und magnetischen Mehrschichtenstruktur (2) besteht, wobei diese Struktur aus einer Stapelung von Schichten (20′) aus einem magnetischen Material gebildet wird, die durch Schichten (21) aus einem unmagnetischen Material voneinander getrennt sind, wobei die Mehrschichtenstruktur so ausgebildet ist, daß die Schichten aus magnetischem Material eine antiferromagnetische Kopplung besitzen, daß der Übergang zwischen dem Zustand der antiparallelen Ausrichtung und dem Zustand der parallelen Ausrichtung in einem sehr engen Magnetfeldintervall erfolgt und daß der Übergang zwischen dem Zustand der antiparallelen Ausrichtung und dem Zustand der parallelen Ausrichtung vom Spin-Flop-Typ ist, dadurch gekennzeichnet, daß die magnetmetallische Mehrschichtenstruktur von mindestens einer zusätzlichen Schicht (4) mit blockierter Magnetisierung bedeckt ist, die ein Polarisationsfeld H_{b} ausübt, dessen Wert sehr nahe dem des Spin-Flop-Feldes H_{sf} ist, um den Übergang zu Magnetfeldwerten zu verschieben, die der Anwendung eines sehr geringen äußeren Magnetfelds entsprechen.

2. Magnetoresistive Sonde nach Anspruch 1, dadurch gekennzeichnet, daß der Spin-Flop-Übergang dadurch erzielt wird, daß die Schichten aus magnetischem Material abwechselnd dünn (20′₂ und 20′₄) und dick sind (20′₁ und 20′₃), mit einem Verhältnis zwischen diesen Dicken von 1 bis 3.

3. Magnetoresistive Sonde nach Anspruch 1, dadurch gekennzeichnet, daß der Spin-Flop-Übergang dadurch erfolgt, daß die Mehrschichtenstruktur aus einer Stapelung von Schichten aus magnetischem Material gleicher Dicke abwechselnd mit Schichten (21) aus unmagnetischem Material gleicher Dichte gebildet wird und daß die Stapelung eine einachsige Anisotropie in der Ebene der Schichten aufweisen.

4. Magnetoresistive Sonde nach Anspruch 1, dadurch gekennzeichnet, daß das magnetische Material aus Eisen, Kobalt und Nickel ausgewählt wird.

5. Magnetoresistive Sonde nach Anspruch 1, dadurch gekennzeichnet, daß das unmagnetische Material aus Mangan, Chrom, Vanadium und Titan ausgewählt wird.

6. Magnetoresistive Sonde nach Anspruch 1, dadurch gekennzeichnet, daß die Schichten aus magnetischem Material eine Dicke zwischen 9 und 90 Å besitzen.

7. Magnetoresistive Sonde nach Anspruch 1, dadurch gekennzeichnet, daß die Schichten aus unmagnetischen Material eine Dicke unter 30 Å besitzen.

8. Magnetoresistive Sonde nach Anspruch 1, dadurch gekennzeichnet, daß die zusätzliche Schicht von einer dicken Eisenschicht gebildet wird.

9. Magnetoresistive Sonde nach Anspruch 1, dadurch gekennzeichnet, daß das magnetische Feldintervall in der Größenordnung von einigen Gauss liegt.

10. Magnetoresistive Sonde nach Anspruch 1, dadurch gekennzeichnet, daß sie durch ein Polarisationsfeld in der Nähe des Übergangsfelds polarisiert wird.

11. Magnetoresistive Sonde nach Anspruch 1, dadurch gekennzeichnet, daß die Mehrschichtenstruktur (2) auf ein Substrat (1) aufgebracht ist.

12. Magnetoresistive Sonde nach Anspruch 11, dadurch gekennzeichnet, daß das Substrat aus einem isolierenden oder einem undotierten Halbleitermaterial mit angepaßter Gitterstruktur besteht.

13. Magnetoresistive Sonde nach einem beliebigen der Ansprüche 11 und 12, dadurch gekennzeichnet, daß die Mehrschichtenstruktur unter Verwendung einer Epitaxialtechnik aufgebracht ist, wie z.B. der Molekularstrahl-Epitaxie.

14. Magnetoresistive Sonde nach einem beliebigen der Ansprüche 1 bis 13, dadurch gekennzeichnet, daß die Mehrschichtenstruktur (2) mit einer Deckschicht (3) bedeckt ist.

## Claims

1. Magnetoresistive-effect sensor, the sensitive element of which is constituted by a monocrystalline magnetic metallic multilayer (2), the multilayer being formed by a stack of layers (20′), made of a magnetic material, which are separated by layers (21) made of a nonmagnetic material, the multilayer being produced in such a way that the layers made of magnetic material exhibit a coupling of the antiferromagnetic type, that the transition between the antiparallel arrangement state and the parallel arrangement state takes place over a very small magnetic field interval, and that the transition between the antiparallel arrangement state and the parallel arrangement state is of the spin-flop type, characterized in that the magnetic metallic multilayer is covered with at least one additional layer (4) having blocked magnetization exerting a polarization field H_{b} whose value is very close to the spin-flop field Hs_{f}, so as to shift the transition towards magnetic field values corresponding to the application of a very low external magnetic field.

2. Magnetoresistive-effect sensor according to Claim 1, characterized in that the spin-flop type transition is produced by the fact that the layers made of magnetic material are alternately thin layers (20′₂ and 20′₄) and thick layers (20′₁ and 20′₃) with a ratio of 1 to 3 between the thicknesses.

3. Magnetoresistive-effect sensor according to Claim 1, characterized in that the spin-flop type transition is produced by the fact that the multilayer is formed by a stack of layers (20) of the same thickness, made of a magnetic material, which is separated by layers (21) of the same thickness, made of a nonmagnetic material, and in that it exhibits uniaxial anisotropy in the plane of the layers.

4. Magnetoresistive-effect sensor according to Claim 1, characterized in that the magnetic material is chosen from iron, cobalt or nickel.

5. Magnetoresistive-effect sensor according to Claim 1, characterized in that the nonmagnetic material is chosen from manganese, chromium, vanadium or titanium.

6. Magnetoresistive-effect sensor according to Claim 1, characterized in that the layers made of magnetic material have a thickness of between 9 and 90 A.

7. Magnetoresistive-effect sensor according to Claim 1, characterized in that the layers made of nonmagnetic material have a thickness less than 30 A.

8. Magnetoresistive-effect sensor according to Claim 1, characterized in that the additional layer is constituted by a thick layer of iron.

9. Magnetoresistive-effect sensor according to Claim 1, characterized in that the magnetic field interval is of the order of a few gauss.

10. Magnetoresistive-effect sensor according to Claim 1, characterized in that it is polarized by a polarization field near the transition field.

11. Magnetoresistive-effect sensor according to Claim 1, characterized in that the multilayer (2) is deposited on a substrate (1).

12. Magnetoresistive-effect sensor according to Claim 11, characterized in that the substrate is produced from an insulating material or from an undoped semiconductor material having a matched unit-cell structure.

13. Magnetoresistive-effect sensor according to either of Claims 11 and 12, characterized in that the deposition is produced by using an epitaxy technique such as molecular beam epitaxy.

14. Magnetoresistive-effect sensor according to any one of Claims 1 to 13, characterized in that the multilayer (2) is covered with an encapsulation layer (3).
